(19) **Europäisches Patentamt / European Patent Office / Office européen des brevets**

(11) **EP 1 460 644 B1**

(12) **EUROPEAN PATENT SPECIFICATION**

(45) Date of publication and mention
of the grant of the patent:
**25.07.2007 Bulletin 2007/30**

(51) Int Cl.:
*H01B 1/22* (2006.01)  *H01B 5/00* (2006.01)
*H05K 1/09* (2006.01)  *C09D 5/24* (2006.01)

(21) Application number: **02793374.6**

(22) Date of filing: **25.12.2002**

(86) International application number:
**PCT/JP2002/013502**

(87) International publication number:
**WO 2003/056574 (10.07.2003 Gazette 2003/28)**

(54) **ELECTROCONDUCTIVE COMPOSITION, ELECTROCONDUCTIVE COATING AND METHOD FOR FORMING ELECTROCONDUCTIVE COATING**

ELEKTROLEITFÄHIGE ZUSAMMENSETZUNG, ELEKTROLEITFÄHIGE BESCHICHTUNG UND VERFAHREN ZUR BILDUNG EINER ELEKTROLEITFÄHIGEN BESCHICHTUNG

COMPOSITION ELECTROCONDUCTRICE, REVETEMENT ELECTROCONDUCTEUR ET PROCEDE DE FORMATION D'UN REVETEMENT ELECTROCONDUCTEUR

(84) Designated Contracting States:
**CH DE FR GB LI NL**

(30) Priority: **27.12.2001 JP 2001398425**
**17.04.2002 JP 2002115438**

(43) Date of publication of application:
**22.09.2004 Bulletin 2004/39**

(60) Divisional application:
**07001372.7 / 1 775 734**

(73) Proprietor: **FUJIKURA LTD.**
**Kohtoh-ku,**
**Tokyo 135-8512 (JP)**

(72) Inventors:
• **TAKAHASHI, Katsuhiko,**
**c/o Fujikura Ltd.**
**Sakura-shi,**
**Chiba 285-0812 (JP)**
• **OHMORI, Kiwako,**
**c/o Fujikura Ltd., Sakura Works**
**Sakura-shi,**
**Chiba 285-0812 (JP)**
• **ENDO, Masanori,**
**c/o Fujikura Ltd., Sakura Works**
**Sakura-shi,**
**Chiba 285-0812 (JP)**

• **YASUHARA, Hikaru,**
**c/o Fujikura Ltd.**
**Kohtoh-ku,**
**Tokyo 135-8512 (JP)**
• **ONO, Akinobu,**
**c/o Fujikura Ltd.**
**Kohtoh-ku,**
**Tokyo 135-8512 (JP)**
• **IMAI, Takayuki,**
**c/o Fujikura Ltd., Sakura Works**
**Sakura-shi,**
**Chiba 285-0812 (JP)**
• **KUROSAWA, Yukihiko,**
**c/o Fujikura Ltd.**
**Kohtoh-ku,**
**Tokyo 135-8512 (JP)**
• **ZAIMA, Hiroaki,**
**c/o Kansai Research Institute**
**Shimogyo-ku,**
**Kyoto-shi,**
**Kyoto 600-8813 (JP)**

(74) Representative: **Verdure, Stéphane**
**Cabinet Plasseraud**
**52 rue de la Victoire**
**75440 Paris Cedex 09 (FR)**

(56) References cited:
JP-A- 4 017 398     JP-A- 4 031 463
JP-A- 5 054 716     JP-A- 10 183 209
JP-A- 2001 240 984

**EP 1 460 644 B1**

**Description**

TECHNICAL FIELD

The present invention relates to an electrically conductive composition used as, for example, an electrically conductive paste, electrically conductive paint or electrically conductive adhesive, a method for forming an electrically conductive coating that uses this electrically conductive composition, and an electrically conductive coating obtained with this formation method, and is capable of adequately enhancing the electrical conductivity of the resulting electrically conductive coating to obtain electrical conductivity that approaches that of metallic silver.

BACKGROUND ART

A typical example of an electrically conductive paste of the prior art consisted of a silver paste obtained by blending and kneading a thermoplastic resin such as acrylic resin or vinyl acetate resin, a binder composed of a thermosetting resin such as epoxy resin or polyester resin, an organic solvent, a curing agent and a catalyst and so forth into flaked silver particles.

This silver paste is widely used as an electrically conductive adhesive or electrically conductive paint in various types of electronic equipment, electronic components, electronic circuits and so forth. In addition, this silver paste is also used as in a flexible printed circuit board, keyboard, various types of switches and other printed circuit boards printed by screen printing and so forth onto a plastic film such as a polyethylene terephthalate film.

This silver paste is used by coating onto a target object by various types of coating methods, and then drying at ordinary temperatures or heating to about 150°C to obtain an electrically conductive coating.

Although varying according to the conditions of film deposition, the volume resistivity of an electrically conductive coating obtained in this manner is within the range of $10^{-4}$ to $10^{-5}$ $\Omega \cdot$cm, which is 10-100 times greater than the volume resistivity of metallic silver of 1.6 x $10^{-6}$ $\Omega \cdot$cm, thus preventing it from attaining the level of electrical conductivity of metallic silver.

The reason for the low electrical conductivity of an electrically conductive coating composed of silver past as in the prior art is that, within an electrically conductive coating obtained from silver paste, only a portion of the silver particles make physical contact thereby resulting in a low number of contact points, there is contact resistance at the contact points, and binder remains between a portion of these silver particles, thereby allowing this binder to impede direct contact between the silver particles.

An example of a method for improving the low level of electrical conductivity of this silver paste consists of coating the silver paste onto a target object, heating to about 800°C to remove the binder by incineration while also melting the silver particles, and fusing the silver particles to form a uniformly continuous metallic silver coating. The volume resistivity of an electrically conductive coating obtained in this manner is about $10^{-6}$ $\Omega \cdot$cm, which is close to that of metallic silver.

However, this method has the disadvantage of the target object being limited to heat-resistant materials such as glass, ceramics and porcelain that can withstand high-temperature heating.

In addition, in the aforementioned flexible circuit board, it is required to make the line width of the electrical circuit formed thereon as narrow as possible. However, since silver particles used in conventional silver paste are in the form of flakes having a particle diameter of 1-100 $\mu$m, it is theoretically impossible to print a circuit having a line width equal to or less than the particle diameter of the flaked silver particles.

Moreover, despite the need to make the line width of electrical circuit as narrow as possible, it is also necessary to simultaneously provide adequate electrical conductivity, and it is necessary to make the thickness of the electrical circuit quite thick in order to meet this requirement. However, when the thickness of an electrical circuit is increased, film deposition becomes increasingly difficult while also resulting in the problem of considerably lowering the flexibility of the circuit itself.

Accordingly, an object of the present invention is to obtain an electrically conductive composition that allows the obtaining of an electrically conductive coating having low volume resistivity and high electrical conductivity comparable to that of metallic silver independent of high-temperature film deposition conditions, while also enabling the line width of an electrical circuit to be sufficiently narrow without it being necessary to increase thickness in the case of forming an electrical circuit of a flexible circuit board and so forth.

The Japanese patent application JP-A-4017398 describes an electrically conductive coating composition comprising particulate silver.

The Japanese patent application JP-A-4031463 describes a conductive circuit material obtained by the deduction of silver trifluoroacetate.

The European patent application EP0826415 describes a silver sol for forming transparent conductive film.

DISCLOSURE OF THE INVENTION

In order to solve the aforementioned problems, the electrically conductive composition of the present invention is composed of a particulate silver compound and a reducing agent. Silver oxide, silver carbonate or silver acetate and so forth can be used for the particulate silver compound. The average particle diameter of the particulate silver compound is 0.01-10 $\mu$m. The reducing agent is a reducing agent such as ethylene glycol.

The electrically conductive coating formation method of the present invention consists of coating an electrically conductive composition followed by heating.

The electrically conductive coating of the present invention is obtained by the aforementioned formation method, consists of mutually fused silver particles, and has a volume resistivity of 3-8 x $10^{-6}$ $\Omega\cdot$cm. In addition, this electrically conductive coating, when obtained by coating the aforementioned electrically conductive composition followed by heating for 30 minutes at 150-200°C satisfies the following formula (1) when W represents the volume resistivity ($\Omega\cdot$cm) of the electrically conductive coating and X represents its specific gravity.

$$W \leq -1.72 \times 10^{-6} \times X + 2.3 \times 10^{-5} \tag{1}$$

Moreover, this electrically conductive coating, when obtained by coating the aforementioned electrically conductive composition followed by heating for 30 minutes at 150-200°C satisfies the following formula (2) when Y represents the number of pores of 100 nm or larger present in a surface area of 10 $\mu$m x 10 $\mu$m on the uppermost surface of the electrically conductive coating, and Z represents the heating temperature (°C).

$$Y < -46.08 \cdot Z + 10112 \tag{2}$$

The particulate silver compound is easily reduced to metallic silver particles by heating in the presence of the reducing agent, and the precipitated metallic silver particles melt due to the heat of reaction during this reduction reaction causing them to mutually fuse and form a metallic silver coating having high electrical conductivity. Consequently, the resulting electrically conductive coating demonstrates electrical conductivity comparable to that of metallic silver.

BRIEF DESCRIPTION OF THE DRAWINGS

Fig. 1 is a scanning electron micrograph of the surface of an electrically conductive coating obtained from the electrically conductive composition of the present invention.
Fig. 2 is a scanning electron micrograph of the surface of an electrically conductive coating obtained from a silver paste of the prior art.
Fig. 3 is a graph showing the relationship between volume resistivity and specific gravity of an electrically conductive coating in a specific example.
Fig. 4 is a graph showing the relationship between the number of surface pores and heating temperature of an electrically conductive coating in a specific example.

BEST MODE FOR CARRYING OUT THE INVENTION

The following provides a detailed explanation of the present invention.

The particulate silver compound used in the electrically conductive composition of the present invention is a compound in the form of solid particles that has the property of becoming metallic silver when reduced by heating in the presence of a reducing agent.

Specific examples of this particulate silver compound include silver oxide, silver carbonate and silver acetate. Two or more types of these compounds may be used by mixing. This particulate silver compound can use an industrially produced particulate silver compound either directly or after grading, or it can be used after being crushed and graded. In addition, a particulate silver compound may be used that has been obtained by a liquid phase method or vapor phase method to be described later.

The average particle diameter of this particulate silver compound is within the range of 0.01-10 $\mu$m, and can be suitably selected according to the conditions of the reduction reagent such as the heating temperature and reducing strength of the reducing agent. In particular, the use of a particulate silver compound having an average particle diameter of 0.5 $\mu$m or less is preferably since this increases the rate of the reduction reaction.

In addition, a particular silver compound having an average particle diameter of 0.5 $\mu$m or less can be produced by a liquid phase method in which silver oxide is obtained by reacting an aqueous alkaline solution such as aqueous sodium hydroxide solution with the product of the reaction with a silver compound and another compound such as an aqueous silver nitrate solution by dropping in while stirring. In this case, a dispersion stabilizer is preferably added to the solution to prevent aggregation of the precipitated particulate silver compound. In this liquid phase method, the particle diameter can be controlled by changing the silver compound concentration, dispersion stabilizer concentration and so forth.

In addition, a vapor phase method can be used to obtain a particulate silver compound having an average particle diameter of 0.1 $\mu$m or less by synthesizing silver oxide by heating a silver halide and oxygen in the vapor phase followed by thermal oxidation.

The reducing agent used in the present invention is capable of reducing the aforementioned particulate silver compound, and its reaction byproduct following the reduction reaction is preferably a gas or highly volatile liquid which does not remain in the electrically conductive coating that is formed. Specific examples of such reducing agents include ethylene glycol, diethylene glycol, triethylene glycol and ethylene glycol diacetate, and one type or two or more types may be used as a mixture.

The amount of this reducing agent used is 20 moles or less, preferably 0.5-10 moles, and more preferably 1-5 moles, with respect to 1 mole of particulate silver compound. When considering reaction efficiency and volatilization by heating, although it is preferable that the amount used be greater than the equimolar amount, addition in excess of the maximum amount of 20 moles ends up being wasteful.

In addition, a dispersion medium is used to disperse or dissolve the particulate silver compound and reducing agent and obtain a liquid electrically conductive composition. Organic solvents such as water, alcohols such as methanol, ethanol and propanol or isophorone, terpineol, triethylene glycol monobutyl ether or butyl cellosolve acetate are used for this dispersion medium.

In addition, in the case the aforementioned reducing agent is a liquid and the particulate silver compound is dispersed, the reducing agent is also able to serve as a dispersion medium, and examples of such a reducing agent include ethylene glycol and diethylene glycol.

Selection of the type of dispersion medium and the amount used vary according to the particulate silver compound and film deposition conditions, for example the mesh coarseness of the screen and the fineness of the printing pattern in the case of screen printing, and are suitably adjusted to as to enable optimum film deposition.

In addition, secondary aggregation of the particulate silver composition is preferably prevented by adding a dispersant and satisfactorily dispersing a particulate silver compound having an average particle diameter of 1 $\mu$m or less. Dispersants such as hydroxypropyl cellulose, polyvinyl pyrrolidone and polyvinyl alcohol are used for this dispersant, and the amount used is 0-300 parts by weight to 100 parts by weight of particulate silver compound.

The electrically conductive composition of the present invention consists of dispersing and dissolving the aforementioned particulate silver compound and reducing agent. In addition, a dispersant may also be added as necessary. The average particle diameter of the particulate silver compound used here has no lower limit, that within a range of 0.01-10 $\mu$m does not cause any particular problems, and the reduction reaction proceeds smoothly even in the case of particles of 1 $\mu$m or larger.

In addition, although varying according to the conditions of film deposition, the viscosity of this electrically conductive composition is preferably 30-300 poise in the case of, for example, screen printing.

The usage method of this electrically conductive composition, namely the formation method of the electrically conductive coating of the present invention, consists of coating this composition onto a target object by a suitable means, followed by simply by heating. The heating temperature is 140-160°C depending on the presence of reducing agent, and the heating time is roughly from 10 seconds to 120 minutes.

Furthermore, the surface of the target object is naturally cleaned before coating.

In an electrically conductive coating of the present invention obtained in this manner, the particulate silver compound is reduced, and the reduced metallic silver particles mutually fuse to form a continuous, metallic silver thin coating.

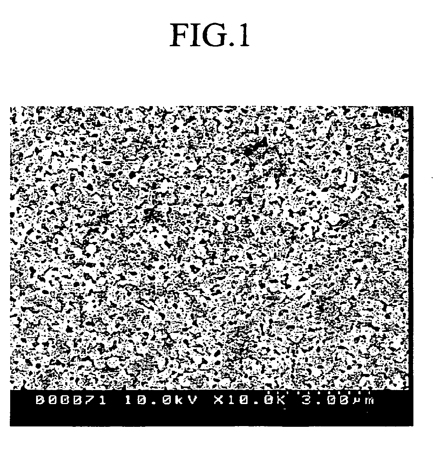

Fig. 1 is a scanning electron micrograph showing an example of an electrically conductive coating obtained in this manner. As is clear from this micrograph, the coating can be understood to be in the form of a continuous coating of metallic silver.

Consequently, the volume resistivity of the electrically conductive coating of the present invention demonstrates a value that reaches 3-8 x $10^{-6}$ $\Omega\cdot$cm, which is on the same order as the volume resistivity of metallic silver.

In addition, since the average particle diameter of the particulate silver compound is 0.01-10 $\mu$m, the line width of an electrical circuit formed by printing this electrically conductive composition on a base material can be made to be 10 $\mu$m or less, and since the electrical conductivity of the circuit itself is extremely high, it is not necessary to increase the thickness of the circuit. Consequently, a circuit can be formed easily and the circuit itself has a high degree of flexibility.

Moreover, since the heating temperature for forming an electrically conductive coating only requires a temperature of 140-160°C, the present invention can be applied to target objects such as plastic film having a low level of heat resistance, which together with allowing the formation of a highly electrically conductive coating, does not lead to thermal degradation of the target object.

Moreover, since the volume resistivity of the resulting electrically conductive coating is extremely low, sufficient electrical conductivity can be obtained even if the thickness of the coating is extremely thin. The coating thickness can be reduced by an amount corresponding to the decrease in volume resistivity relative to an electrically conductive paste of the prior art. For example, in the case of having used a silver paste having volume resistivity of $5 \times 10^{-5}$ $\Omega\cdot$cm, since volume resistivity of $3 \times 10^{-6}$ $\Omega\cdot$cm can be realized by the present invention in the case of specifications requiring a circuit having a thickness of 50 $\mu$m, the electrically conductive coating can be made to have a thickness of 3 $\mu$m.

In addition, since the surface on the base material side of the resulting electrically conductive coating presents a mirrored surface rich in the luster of metallic silver, the back surface of a plastic film or other transparent base material or the top surface on the side of the base material of an electrically conductive coating separated from the base material can be used in household and industrial applications as a mirror offering a high level of reflectance, such as in a reflecting mirror of the resonator of a laser device.

In addition, the following relationship was clearly demonstrated to be valid with respect to an electrically conductive coating obtained from the electrically conductive composition of the present invention.

Namely, when the volume resistivity and specific gravity were measured for an electrically conductive coating obtained by coating the aforementioned electrically conductive composition onto a glass plate or other base material followed by heating for 30 minutes at 150-200°C to determine the relationship between these two parameters, the aforementioned formula (1) was clearly determined to be satisfied when W represents the volume resistivity ($\Omega\cdot$cm) of the electrically conductive coating and X represents its specific gravity.

Thus, a satisfactory electrically conductive coating can be obtained by defining the specific gravity of the resulting electrically conductive coating so that its volume resistivity is lower than the value of formula (1).

In addition, when the number of pores present per unit surface area in the uppermost surface of an electrically conductive film obtained in the same manner were determined by observing with a scanning electron microscope to determine the relationship between the number of pores and heating temperature, the aforementioned formula (2) was clearly determined to be satisfied when Y represents the number of pores of 100 nm or larger present over a surface area of 10 $\mu$m x 10 $\mu$m in the uppermost surface of the electrically conductive coating, and Z represents the heating temperature (°C).

On the basis of this relationship, it was found that the heating temperature should be suitably controlled to form a satisfactory electrically conductive coating having few pores, and that an electrically conductive film having a small number of pores and a high level of electrical conductivity is obtained by heating at about 180-200°C. The following provides a description of specific examples.

Example 1

0.17 g of silver nitrate were dissolved in 50 ml of ion exchange water followed by dissolving 0.05-0.5 g of hydroxypropyl cellulose (dispersant) therein to prepare an aqueous solution. 0.9-5 ml of a 1 M aqueous sodium hydroxide solution were then dropped into this aqueous solution while stirring after which stirring was continued for 10-30 minutes to obtain a silver oxide suspension.

Next, excess ions were removed by washing the silver oxide 2-5 times with methanol. 0.06-1 g of ethylene glycol (reducing agent) were then added and mixed to produce a paste-like electrically conductive composition of the present invention.

After forming this electrically conductive composition into a pattern having a thickness of 5-10 $\mu$m on 0.1 mm thick polyethylene terephthalate film by screen printing, the pattern was heated in an oven for 30 minutes to 3 hours at 150°C.

The volume resistivity of the resulting patterns were $3-6 \times 10^{-6}$ $\Omega\cdot$cm, and observation of the surface with a scanning electron microscope revealed that silver particles that had been reduced and precipitated from the silver oxide had fused and joined together as shown in Fig. 1.

Example 2

For the sake of comparison, a commercially available silver paste (Fujikura Kasei, trade name: "FA-353") was used to form a pattern having a thickness of 5-10 $\mu$m on a 0.1 mm thick polyethylene terephthalate film by screen printing followed by heating for 30 minutes at 150°C in an oven.

The volume resistivity of the resulting pattern was $4 \times 10^{-5}$ $\Omega\cdot$cm, and observation of surface with a scanning electron microscope revealed a state in which the silver flakes were merely making contact.

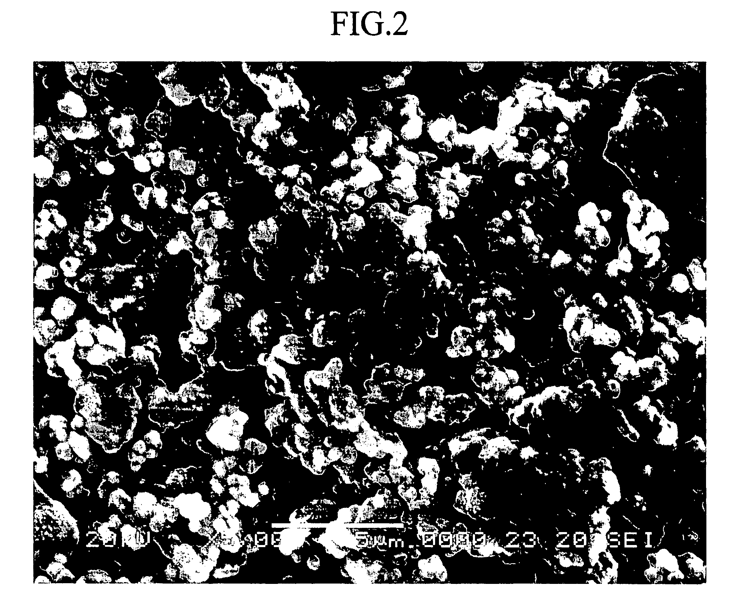

In addition, when a pattern was similarly formed using a different commercially available silver paste (Asahi Kasei Laboratories), the volume resistivity was $3 \times 10^{-5}$ $\Omega \cdot cm$, and observation of the surface with a scanning electron microscope revealed a state in which the silver flakes were merely making contact as shown in the scanning electron micrograph of Fig. 2.

Example 3

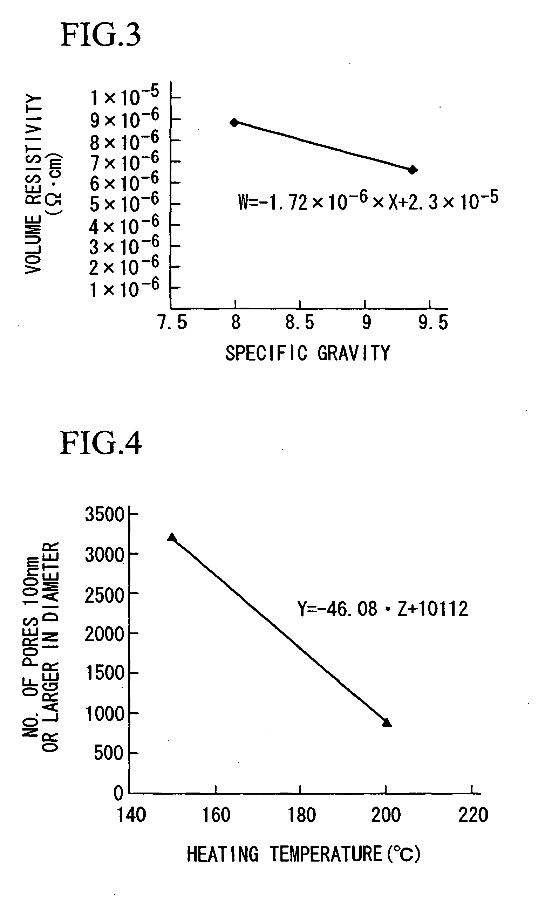

When the electrically conductive composition in the aforementioned Example 1 was coated in an equal amount onto a glass plate to a thickness of 5-10 $\mu$m, and then heated in an oven under conditions of 30 minutes at 150°C and then 30 minutes at 200°C, followed by measuring the volume resistivity and specific gravity of the resulting electrically conductive film to determine their relationship, results like the graph shown in Fig. 3 were obtained.

Determination of a regression formula from this graph yielded the aforementioned formula (1).

In addition, when the surface of an electrically conductive coating produced in the same manner was observed with a scanning electron microscope followed by calculation of the number of pores present in the uppermost surface to determine the relationship between the number of pores and heating temperature, results like the graph shown in Fig. 4 were obtained.

Determination of a regression formula from this graph yielded the aforementioned formula (2).

Example 4

Electronically conductive coatings were formed using 100 parts by weight of silver oxide for the particulate silver compound and 75 parts by weight of ethylene glycol for the reducing agent while changing the average particle diameter of the silver oxide, followed by measurement of volume resistivity. In addition, the presence of fusion of silver particles was also observed with a scanning electron microscope.

Polyethylene terephthalate film having a thickness of 0.1 mm was used for the base material, and binder having a thickness of 5-10 $\mu$m was form on this base material by screen printing followed by heating for 30 minutes to 3 hours at 150°C.

Silver oxide having an average particle diameter of 0.01 $\mu$m was produced by a vapor phase method, that having an average particle diameter of 0.1-1.5 $\mu$m was produced by a liquid phase method, and that having an average particle diameter of 10-15 $\mu$m was used by grading commercially available products.

The results are shown in Table 1.

Table 1

| Test No. | 1 | 2 | 3 | 4 | 5 | 6 | 7 | 8 |
|---|---|---|---|---|---|---|---|---|
| Silver oxide avg. particle diameter ($\mu$m) | 0.01 | 0.1 | 0.25 | 0.8 | 1.5 | 5 | 10 | 15 |
| Volume resistivity ($\Omega \cdot cm$) | $3 \times 10^{-6}$ to $6 \times 10^{-6}$ | $3 \times 10^{-6}$ to $6 \times 10^{-6}$ | $3 \times 10^{-6}$ to $7 \times 10^{-6}$ | $5 \times 10^{-6}$ to $9 \times 10^{-6}$ | $8 \times 10^{-6}$ to $1 \times 10^{-5}$ | $8 \times 10^{-6}$ to $1 \times 10^{-5}$ | $8 \times 10^{-6}$ to $3 \times 10^{-5}$ | $9 \times 10^{-5}$ to $8 \times 10^{-4}$ |
| Fusion between silver particles | Yes | Yes | Yes | Yes | Yes | Yes | Yes | Partial |

Based on the results of Table 1, although volume resistivity increases the larger the average particle diameter, if the average particle diameter is within the range of 0.01-10 $\mu$m, the volume resistivity is on the order of $10^{-6}$ $\Omega \cdot cm$, thereby allowing the formation of an electrically conductive coating that does not present any problems in terms of practical use.

Example 5

Electrically conductive coatings were formed by using silver oxide having an average particle size of 0.25 $\mu$m for the particulate silver compound while changing the types and combinations of reducing agents followed by measurement of volume resistivity. In addition, the presence of fusion of silver particles was also observed with a scanning electron microscope. A total of 75 parts by weight of reducing agent were blended into 100 parts by weight of silver oxide.

Polyethylene terephthalate film having a thickness of 0.1 mm was used for the base material, and a pattern having a thickness of 5-10 $\mu$m was formed thereon by screen printing followed by heating for 30 minutes to 3 hours at 150°C. The results are shown in Table 2.

Table 2

| Test No. | 9 | 10 | 11 | 12 | 13 |
|---|---|---|---|---|---|
| Type of reducing agent | Blended Amount (parts by weight) | | | | |
| Ethylene glycol | | | | 32.5 | 32.5 |
| Diethylene glycol | 75 | | | 32.5 | |
| Triethylene glycol | | 75 | | | |
| Ethylene glycol diacetate | | | 75 | | 32.5 |
| Volume resistivity ($\Omega \cdot$cm) | $3 \times 10^{-6}$ to $8 \times 10^{-6}$ | $5 \times 10^{-6}$ to $1 \times 10^{-5}$ | $5 \times 10^{-6}$ to $1 \times 10^{-5}$ | $3 \times 10^{-6}$ to $8 \times 10^{-6}$ | $5 \times 10^{-6}$ to $9 \times 10^{-6}$ |
| Fusion of silver particles | Yes | Yes | Yes | Yes | Yes |

Based on the results of Table 2, volume resistivity was on the order of $10^{-6}$ $\Omega \cdot$cm and an electrically conductive coatings were able to be formed that did not present problems in terms of practical use even if the types and combinations of reducing agents were changed.

Example 6

Electrically conductive coatings were produced while changing the types and combinations of particulate silver compounds followed by measurement of volume resistivity. In addition, the presence of fusion of silver particles was also observed with a scanning electron microscope.

Ethylene glycol was used for the reducing agent, and was blended at 75 parts by weight to 100 parts by weight of particulate silver compound.

Polyethylene terephthalate film having a thickness of 0.1 mm was used for the base material, and a pattern having a thickness of 5-10 $\mu$m was formed thereon by screen printing followed by heating for 30 minutes to 3 hours at 150°C.

The results are shown in Tables 3 and 4.

Table 3

| Test No. | 14 | 15 | 16 | 17 | 18 |
|---|---|---|---|---|---|
| Particulate silver compound | Silver carbonate | Silver carbonate | Silver carbonate | Silver acetate | Silver acetate |
| Avg. particle diameter ($\mu$m) | 0.1 | 1.5 | 5 | 5 | 10 |
| Volume resistivity ($\Omega \cdot$cm) | $4 \times 10^{-6}$ to $7 \times 10^{-6}$ | $7.5 \times 10^{-6}$ to $1 \times 10^{-5}$ | $8 \times 10^{-6}$ to $1.2 \times 10^{-5}$ | $6.5 \times 10^{-6}$ to $1 \times 10^{-5}$ | $8 \times 10^{-6}$ to $3.4 \times 10^{-5}$ |
| Fusion of silver particles | Yes | Yes | Yes | Yes | Yes |

Table 4

| Test No. | 19 | 20 | 21 | 22 | 23 | 24 | 25 |
|---|---|---|---|---|---|---|---|
| Particulate silver compound | Silver oxide | Silver oxide | Silver oxide | Silver oxide | Silver carbonate | Silver oxide | Silver oxide |
| Avg. particle diameter ($\mu$m) | 0.25 | 0.25 | 0.25 | 5 | 0.35 | 0.25 | 0.25 |
| Blending ratio (wt%) | 50 | 70 | 50 | 60 | 50 | 33 | 50 |
| Particulate silver compound | Silver carbonate | Silver carbonate | Silver acetate | Silver acetate | Silver acetate | Silver carbonate | Silver carbonate |
| Avg. particle diameter ($\mu$m) | 0.35 | 5 | 5 | 5 | 5 | 0.35 | 5 |
| Blending ratio (wt %) | 50 | 30 | 50 | 40 | 50 | 33 | 25 |
| Particulate silver compound | - | - | - | - | - | Silver acetate | Silver acetate |
| Avg. particle diameter ($\mu$m) | - | - | - | - | - | 5 | 5 |
| Blending ratio (wt%) | - | - | - | - | - | 34 | 25 |
| Volume resistivity ($\Omega \cdot$cm) | $4 \times 10^{-6}$ to $6.7^{-6}$ | $7 \times 10^{-6}$ to $8.3 \times 10^{-6}$ | $6.2 \times 10^{-6}$ to $8.5 \times 10^{-6}$ | $8 \times 10^{-6}$ to $1.2 \times 10^{-5}$ | $5.4 \times 10^{-6}$ to $9.1 \times 10^{-6}$ | $4.2 \times 10^{-6}$ to $7 \times 10^{-6}$ | $7.9 \times 10^{-6}$ to $1.1 \times 10^{-5}$ |
| Fusion of silver particles | Yes | Yes | Yes | Yes | Yes | Yes | Yes |

Based on the results of Table 3 and Table 4, volume resistivity was on the order of $10^{-6}$ $\Omega \cdot$cm and an electrically conductive coatings were able to be formed that did not present problems in terms of practical use even if silver oxide, silver carbonate, silver acetate or their combinations were changed.

As has been explained above, according to the electrically conductive composition of the present invention, an electrically conductive coating can be obtained that has extremely high electrical conductivity. In addition, since the formation of this electrically conductive coating is sufficiently carried out by heating at a comparatively low temperature, plastic and other materials having a low level of heat resistance can be used for the base material. Moreover, this electrically conductive composition allows the line width of an electrical circuit to be adequately narrow when forming an electrical circuit, and it is not necessary to increase its thickness.

INDUSTRIAL APPLICABILITY

The electrically conductive composition of the present invention is used as an electrically conductive paste, electrically conductive paint or electrically conductive adhesive and so forth. In addition, it can also be used to form an electrical circuit of a printed wiring board such as a flexible printed circuit board. Moreover, this electrically conductive coating can also be used as a reflective thin film having high reflectance.

### Claims

1. An electrically conductive composition containing a particulate silver compound and a reducing agent, wherein the reducing agent is one or more types of ethylene glycol, diethylene glycol, triethylene glycol or ethylene glycol diacetate.

2. An electrically conductive composition according to claim 1 wherein the particulate silver compound is one type or two or more types of silver oxide, silver carbonate and silver acetate.

3. An electrically conductive composition according to claim 1 or claim 2, wherein, the average particle diameter of the particulate silver compound is 0.01-10 $\mu$m.

4. An electrically conductive coating formation method comprising coating the electrically conductive composition according to any of claims 1 through 3 followed by heating.

### Patentansprüche

1. Elektroleitfähige Zusammensetzung, die eine aus Partikeln bestehende Silberverbindung und ein Reduktionsmittel enthält, wobei das Reduktionsmittel aus einer oder mehreren Arten von Ethylenglykol, Diethylenglykol, Triethylenglykol und Ethylenglykoldiacetat ist.

2. Elektroleitfähige Zusammensetzung gemäß Patentanspruch 1, wobei die aus Partikeln bestehende Silberverbindung aus einer oder mehreren Arten Silberoxid, Silberkarbonat und Silberazetat ist.

3. Elektroleitfähige Zusammensetzung gemäß Patentanspruch 1 oder 2, wobei der durchschnittliche Partikeldurchmesser der aus Partikeln bestehenden Silberverbindung 0,01 - 10 $\mu$m ist.

4. Verfahren zur Herstellung einer elektroleitfähigen Beschichtung umfassend das Beschichten mit einer elektroleitfähigen Zusammensetzung gemäß einem der Patentansprüche 1 bis 3 und anschließend das Erhitzen.

### Revendications

1. Une composition conductrice de l'électricité contenant un composé d'argent sous forme de particules et un agent réducteur, dans lequel l'agent réducteur consiste en un ou plusieurs types d'éthylèneglycol, de diéthylèneglycol, de triéthylèneglycol ou de diacétate d'éthylèneglycol.

2. Une composition conductrice de l'électricité selon la revendication 1, dans laquelle le composé d'argent sous forme de particules consiste en un type, ou deux types ou plus, d'oxyde d'argent, de carbonate d'argent et d'acétate d'argent.

3. Une composition conductrice de l'électricité selon la revendication 1 ou la revendication 2, dans laquelle le diamètre de particules moyen du composé d'argent sous forme de particules est de 0,01 - 10 $\mu$m.

4. Un procédé de formation de revêtement conducteur de l'électricité, comprenant l'application d'une couche de la composition conductrice de l'électricité selon l'une quelconque des revendications 1 à 3, suivie d'un chauffage.

# FIG.1

000071  10.0kV  X10.0K  3.00μm

FIG.2

## FIG.3

VOLUME RESISTIVITY ($\Omega \cdot cm$)

$1 \times 10^{-5}$
$9 \times 10^{-6}$
$8 \times 10^{-6}$
$7 \times 10^{-6}$
$6 \times 10^{-6}$
$5 \times 10^{-6}$
$4 \times 10^{-6}$
$3 \times 10^{-6}$
$2 \times 10^{-6}$
$1 \times 10^{-6}$

$W=-1.72 \times 10^{-6} \times X+2.3 \times 10^{-5}$

7.5    8    8.5    9    9.5

SPECIFIC GRAVITY

## FIG.4

NO. OF PORES 100nm OR LARGER IN DIAMETER

3500
3000
2500
2000
1500
1000
500
0

$Y=-46.08 \cdot Z+10112$

140    160    180    200    220

HEATING TEMPERATURE (°C)

**EP 1 460 644 B1**

## REFERENCES CITED IN THE DESCRIPTION

**Patent documents cited in the description**

- JP 4017398 A
- JP 4031463 A
- EP 0826415 A